# EUROPEAN PATENT APPLICATION

(11) **EP 4 444 064 A1**
(43) Date of publication of application: **09.10.2024**
(21) Application number: 24154903.9
(22) Date of filing: 31.01.2024
(51) Int. Cl.: H10K 59/131, H10K 59/124, H10K 59/80, H10K 50/844

(54) **DISPLAY DEVICE AND MANUFACTURING METHOD THEREOF**

(30) Priority: 06.04.2023 US 202363494528 P; 12.10.2023 CN 202311326621
(71) Applicant: Taizhou Guanyu Technology Co., Ltd., Taizhou City, Zhejiang Province (CN)
(72) Inventor: HSU, KUO-CHENG, 406 TAICHUNG CITY (TW); CHU, KER TAI, 11494 TAIPEI CITY (TW); CHEN, HUEI-SIOU, 103 TAIPEI CITY (TW)
(74) Representative: Michalski Hüttermann & Partner Patentanwälte mbB

(57) **Abstract**

A display device includes a substrate, an interconnection conductive layer, a bonding pad, a passivation layer, first and second through vias, a light emitting structure and a film. The substrate includes active and peripheral regions. The interconnection conductive layer is disposed on the substrate and in the active region. The bonding pad is disposed on the substrate and in the peripheral region. The passivation layer is disposed on the interconnection conductive layer and the bonding pad. The first through via passes through the passivation layer and is electrically connected to the interconnection conductive layer. The light emitting structure is disposed on the first through via. The film is disposed on the light emitting structure and covers the peripheral region of the substrate. The second through via passes through the film and a portion of the passivation layer and is electrically connected to the bonding pad.

## Description

### CROSS REFERENCE TO RELATED APPLICATIONS

This application claims the benefit of CN Application No. 202311326621.4, filed on October 12, 2023 and the US provisional application No 63/494,528 , filed on April 6, 2023, the disclosure of which is hereby incorporated by reference in its entirety.

### BACKGROUND OF THE PRESENT DISCLOSURE

### FIELD OF THE PRESENT DISCLOSURE

The present disclosure relates to a display device, and more particularly to a display device having a through via.

### DESCRIPTION OF THE PRIOR ART

Display devices including an optical component layer are extensively applied in most electronic apparatuses, and there has been an increasing demand for large-scale display devices in the recent years. However, a method for manufacturing a display device contains steps with poor light extraction rates. In fact, one commonly known challenge is how to improve the light extraction rate of a display device. Thus, the industry of display devices seeks a method for solving the issue above.

### SUMMARY OF THE PRESENT DISCLOSURE

A display device includes a substrate, an interconnection conductive layer, a bonding pad, a passivation layer, a first through via, a light emitting structure, a film and a second through via. The substrate includes an active region and a peripheral region. The interconnection conductive layer is disposed on the substrate and located in the active region. The bonding pad is disposed on the substrate and located in the peripheral region. The passivation layer is disposed on the interconnection conductive layer and the bonding pad. The first through via passes through the passivation layer and is electrically connected to the interconnection conductive layer. The light emitting structure is disposed on the first through via. The film is disposed on the light emitting structure and covers the peripheral region of the substrate. The second through via passes through the film and a portion of the passivation layer and is electrically connected to the bonding pad.

A method for manufacturing a display device includes: providing a substrate including an active region and a peripheral region; forming an interconnection conductive layer on the substrate and in the active region; forming a bonding pad on the substrate and in the peripheral region; forming a passivation layer on the interconnection conductive layer and the bonding pad; forming a first through via passing through the passivation layer and electrically connected to the interconnection conductive layer; forming a light emitting structure on the first through via; forming a film on the light emitting structure and covering the active region and the peripheral region of the substrate; and forming a second through via passing through the film and the passivation layer and electrically connected to the bonding pad.

### BRIEF DESCRIPTION OF THE DRAWINGS

FIG. 1A is a top view of a display device according to some embodiments;
FIG. 1B is a cross-sectional view of the display device in FIG. 1A according to some embodiments;
FIGS. 2A, 2B, 2C, 2D, 2E, 2F, 2G and 2H are diagrams of a display device in different manufacturing stages of a method according to some embodiments of the present disclosure; and
FIG. 3 is a cross-sectional view of a display device according to some embodiments.

### DETAILED DESCRIPTION OF THE EMBODIMENTS

Numerous different embodiments or examples are provided in the present disclosure below to implement different characteristics of the present application. Specific examples of components and configurations are as described below in the aim of simplifying the disclosure of the present application. However, these examples are merely examples and are not to be construed as limitations to the present application. For example, a first feature formed on, over or above a second feature can include an embodiment in which the first and second features are in direct contact, and can also include an embodiment in which another feature is formed between the first and second features and the first and second features are thus not in direct contact.

Moreover, numerals, symbols and/or letters may be repeated in different components. Such repetition is for the purpose of simplicity and clarity, and does not dictate relations between the various embodiments and/or structures discussed. In addition, spatial correspondence terms used in the present application such as "under", "lower than", "below", "more that", "higher than" and the like can be used for simple description so as to explain a relation of one element or feature in a drawing with respect to another element or feature. In addition to orientations illustrated in the drawings, these spatial correspondence terms further include different orientations of an apparatus in use or in operation. An apparatus can be oriented (rotated by 90 degrees or other orientations), and the spatial correspondence description used in the present application can be interpreted accordingly.

Despite that numeric ranges and parameters disclosed in the broadest range of the present disclosure are approximate values, the values stated in specific embodiments are to be as accurate as possible. However, any numeral intrinsically includes a certain error caused by a standard deviation obtained from individual testing and measurement. Moreover, in the literature below, the term "about/approximate" usually refers to less than 10%, 5%, 1% or 0.5% of a predetermined value or range. Alternatively, the term "about/approximate" refers to within an acceptable standard error of a mean value considered by a person of ordinary skill in the art. Apart from operation /working examples, unless otherwise specified, it is to be understood that the amount, period of time, temperature, operating conditions, ratio of quantity of materials, as well as all numerical ranges, quantities, values and ratios of the like, are to be modified by the term "about/approximate" in all circumstances. Thus, unless described otherwise, the numerical values and parameters of the claims set forth in the present disclosure can be regarded as approximate value that are variable according to requirements. Each numerical value or parameter is to be interpreted at least in light of a quantity of effective numbers reported and by applying common rounding techniques. In the present disclosure, a range can represent from one endpoint to the other endpoint, or between these two endpoints. Unless otherwise specified, all ranges disclosed in the present literature include endpoints.

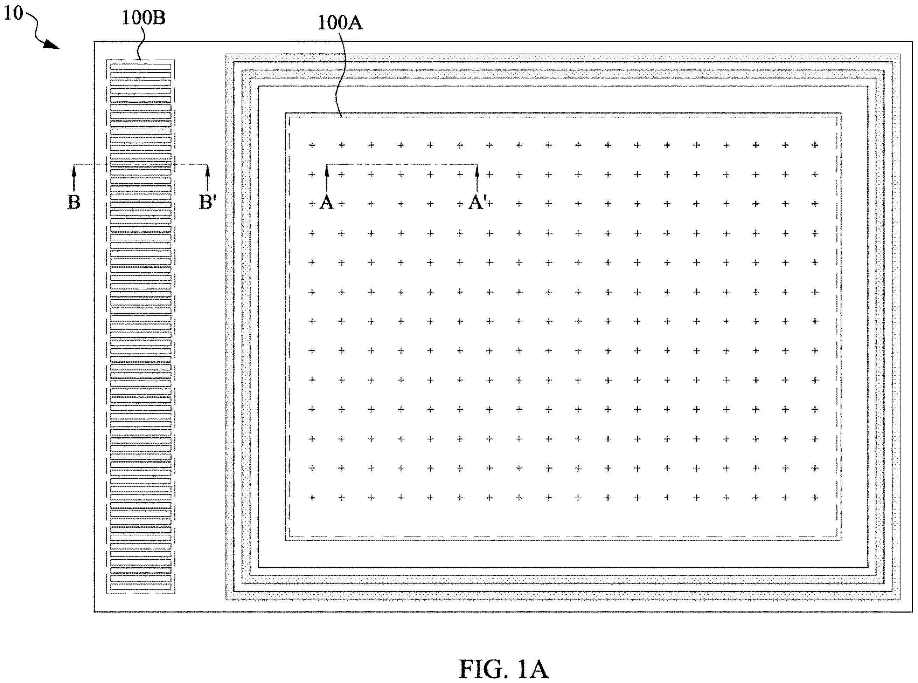

FIG. 1A shows a top view of a display device 10 according to some embodiments. The display device 10 can include a substrate 100. The substrate 100 includes a base material, a dielectric layer, and one or more circuits (not shown) disposed on the base material or in the base material. In some embodiments, the base material is a transparent base material, or is at least partially transparent. In some embodiments, the base material is a non-flexible base material, and a material of such base material can include glass, quartz, low-temperature polysilicon (LTPS) or other appropriate materials. In some embodiments, the base material is a flexible substrate, and a material of such base material can include transparent epoxy resin, polyimide, polyvinyl chloride, methyl methacrylate or other appropriate materials. The dielectric layer is disposed on the base material as needed. In some embodiments, the dielectric layer can include silicon oxide, silicon nitride, silicon oxynitride, or other appropriate materials.

In some embodiments, the circuit can include a complementary metal oxide semiconductor (CMOS) circuit, or multiple transistors and multiple capacitors adjacent to the transistors, wherein the transistors and the capacitors are formed on the dielectric layer. In some embodiments, each of the transistors is a thin-film transistor (TFT). Each of the transistors includes a source/drain region (including at least one source region and one drain region), a channel region located in the source-drain region, a gate electrode disposed above the channel region, and a gate insulator located between the channel region and the gate electrode. The channel region of the transistor may include a semiconductor material, for example, silicon or other elements selected from group IV or group III and group V.

The substrate 100 can include an active region 100A and a peripheral region 100B. The active region 100A can be configured to emit light. The active region 100A can include a plurality of pixels, each of which can be configured to emit light of a predetermined wavelength, for example, green light (for example, light of a wavelength between 500 nm and 580 nm), red light (for example, light of a wavelength between 620 nm and 780 nm), blue light (for example, light of a wavelength between 400 nm and 500 nm), infrared light, ultraviolet light and/or white light. In some embodiments, the active region 100A can include a light emitting diode (LED), an organic light emitting diode (OLED), a quantum dot light emitting diode (QLED) and/or other appropriate light emitting modules. The peripheral region 100B can be configured to be electrically connected to an external circuit (not shown), which can be a driver chip, a circuit board and/or other appropriate circuits.

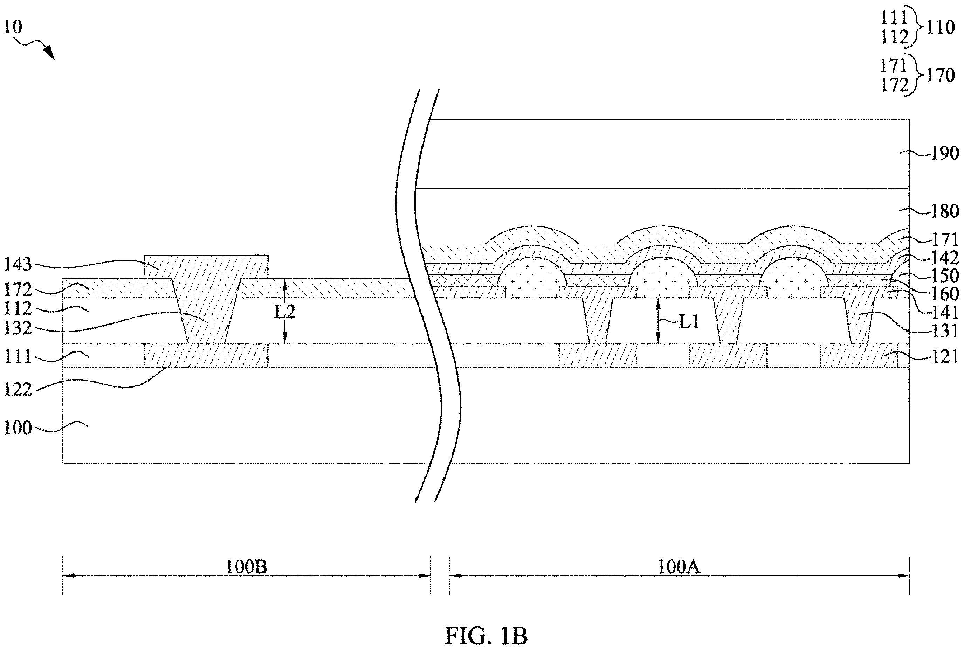

FIG. 1B shows a cross-sectional view of the display device 10 in FIG. 1A according to some embodiments.

In some embodiments, the display device 10 includes an interlayer dielectric (ILD) structure 110. The interlayer dielectric structure 110 can be disposed on the substrate 100. The interlayer dielectric structure 110 can include a plurality of passivation layers. For example, the interlayer dielectric structure 110 includes a passivation layer 111 and a passivation layer 112. The passivation layer 111 can be disposed on the substrate 100 and include a dielectric material, for example, borophosphosilicate glass (BPSG) or other appropriate materials.

In some embodiments, the display device 10 includes an interconnection conductive layer 121 and a bonding pad 122. The interconnection conductive layer 121 is disposed on the substrate 100 and located in the active region 100A. The interconnection conductive layer 121 is embedded in the passivation layer 111. The interconnection conductive layer 121 can be electrically connected to a TFT, an interconnection conductive layer or other appropriate components in the substrate 100. In some embodiments, the interconnection conductive layer 121 can be the fourth metal layer M4, fifth metal layer M5, sixth metal layer M6 or other appropriate horizontal layers. The interconnection conductive layer 121 can include a conductive material, for example, a metal, a metal oxide, an alloy and/or other appropriate materials. It should be noted that, other interconnection conductive layers, for example, the first metal layer M1 and second metal layer M2 can be located in or within the substrate 100, and electrically connected to the interconnection conductive layer 121 and/or the bonding pad 122.

The bonding pad 122 is disposed on the substrate 100 and located in the peripheral region 100B. The bonding pad 122 is embedded in the passivation layer 111. A height of the bonding pad 122 relative to the substrate 100 can be substantially equal to a height of the interconnection conductive layer 121 relative to the substrate 100. In some embodiments, a surface area (for example, a surface area of an upper surface) of the bonding pad 122 can be greater than a surface area of the interconnection conductive layer 121. The dimension (e.g., width in a cross-sectional view or a diameter) of the bonding pad 122 is substantially uniform.

The passivation layer 112 is disposed on the passivation layer 111. The passivation layer 112 disposed on the interconnection conductive layer 121. The passivation layer 112 is disposed on the bonding pad 122. A material forming the passivation layer 112 can be the same as a material forming the passivation layer 111.

In some embodiments, the display device 10 includes a conduction via 131. The conduction via 131 is located in the active region 100A. The conduction via 131 can be disposed on the interconnection conductive layer 121 and electrically connected to the interconnection conductive layer 121. The conduction via 131 can pass through the passivation layer 112. The conduction via 131 is tapered toward the substrate 100.

In some embodiments, the display device 10 includes an electrode 141. The electrode 141 is disposed on the conduction via 131 and electrically connected to the interconnection conductive layer 121. The electrode 141 can define a plurality of openings (not shown), and a surface of the passivation layer 112 can be exposed from the openings of the electrode 141. The electrode 141 includes a metal material, for example, Ag and Mg. In some embodiments, the electrode 141 includes indium tin oxide (ITO), indium zinc oxide (IZO) or other appropriate materials.

In some embodiments, the display device 10 includes a pixel defining layer 150. The pixel defining layer 150 is disposed on a surface of the interconnection conductive layer 121. The pixel defining layer 150 can cover a part of the electrode 141. The pixel defining layer 150 can be configured to define a position of a pixel. The pixel defining layer 150 can be configured to define a light emitting area and/or profile of a pixel. In some embodiments, the pixel defining layer 150 includes a light absorbing material having an absorption rate greater than 85%, for example, 85%, 88%, 90%, 93%, 95%, 97%, 98% or 99%. The pixel defining layer 150 can include an organic material, for example, a photoresist or other appropriate materials.

In some embodiments, the display device 10 includes a light emitting structure 160. The light emitting structure 160 can be disposed on the electrode 141. The light emitting structure 160 can be located in an opening defined by the pixel defining layer 150. In some embodiments, the light emitting structure 160 can include a multi-layer composite structure. For example, the light emitting structure 160 can include a carrier injection layer, a hole transportation layer (HTL), an electron transportation layer (ETL), an emissive layer (EML) and/or other appropriate materials. The carrier injection layer is for injecting holes and/or electrons. The hole transportation layer and the electron transportation layer have characteristics of uni-directionally transporting electrons or holes. The emissive layer can include different materials at different pixels so as to emit light of with wavelengths in different wavebands, for example, red light, green light, blue light, white light, ultraviolet light, infrared light and/or light of other wavebands.

In some embodiments, the display device 10 includes an electrode 142. The electrode 142 is disposed on the light emitting structure 160. A material of the electrode 142 can be the same as or similar to a material of the electrode 141.

In some embodiments, the display device 10 includes a film 170. The film 170 can serve as a buffer layer and/or protection layer, so as to prevent the components below from damage. The film 170 can include a dielectric material. The film 170 can include a portion 171 and a portion 172. The portion 171 is located in the active region 100A. The portion 171 can be conformally disposed on the electrode 142.

The portion 172 is disposed on the passivation layer 112. The portion 172 can be located in the peripheral region 100B. In some embodiments, a height of the portion 171 relative to the substrate 100 is different from a height of the portion 172 relative to the substrate 100.

In some embodiments, the display device 10 includes a flat layer 180. The flat layer 180 may be configured to provide a substantially flat upper surface. The flat layer 180 is disposed on the film 170. The flat layer 180 includes a substantially transparent material, for example, resin or other appropriate materials, and can include any desired filler.

In some embodiments, the display device 10 includes a cover plate 190. The cover plate 190 can be disposed in the active region 100A. The peripheral region 100B is not covered by the cover plate 190. The cover plate 190 is disposed on the flat layer 180. In some embodiments, the cover plate 190 includes a substantially transparent component, for example, glass or other appropriate components.

In some embodiments, the display device 10 includes a conduction via 132. The conduction via 132 is located in the peripheral region 100B. The conduction via 132 can be disposed on the bonding pad 122 and electrically connected to the bonding pad 122. In some embodiments, an aperture of the conduction via 132 can continuously decrease from a surface (for example, an upper surface) of the portion 172 to a surface (for example, an upper surface) of the bonding pad 122. In some embodiments, the conduction via 132 passes through the passivation layer 112. In some embodiments, the conduction via 132 passes through the portion 172. In some embodiments, a size (for example, an aperture or a diameter) of the conduction via 132 can be greater than a size of the conduction via 131. The conduction via 131 has a length L1 (or depth). The conduction via 132 has a length L2 (or depth). In some embodiments, the length L1 is less than the length L2. It should be noted that, in other embodiments, the display device 10 can include other dielectric layers or components (not shown) located above the film 170, and at this point, the conduction via 131 can pass through or penetrate through the dielectric layers or components above.

In some embodiments, the display device 10 includes a liner 143. The liner 143 can be disposed on the conduction via 132 and electrically connected to the bonding pad 122. The liner 143 can be used to electrically connect to an external circuit, for example, a driver chip, a circuit board and/or other appropriate circuits.

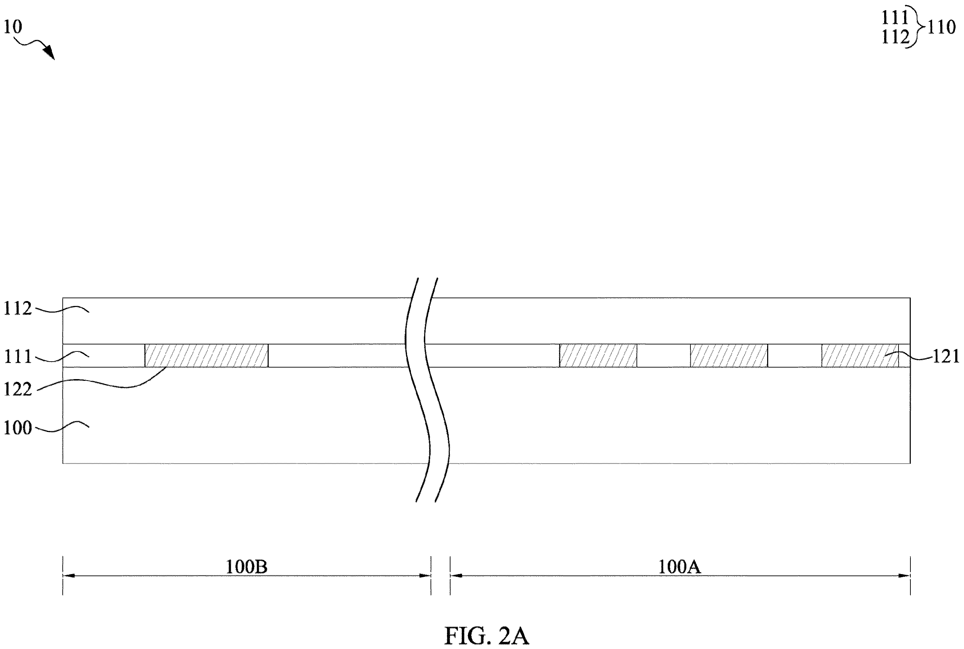

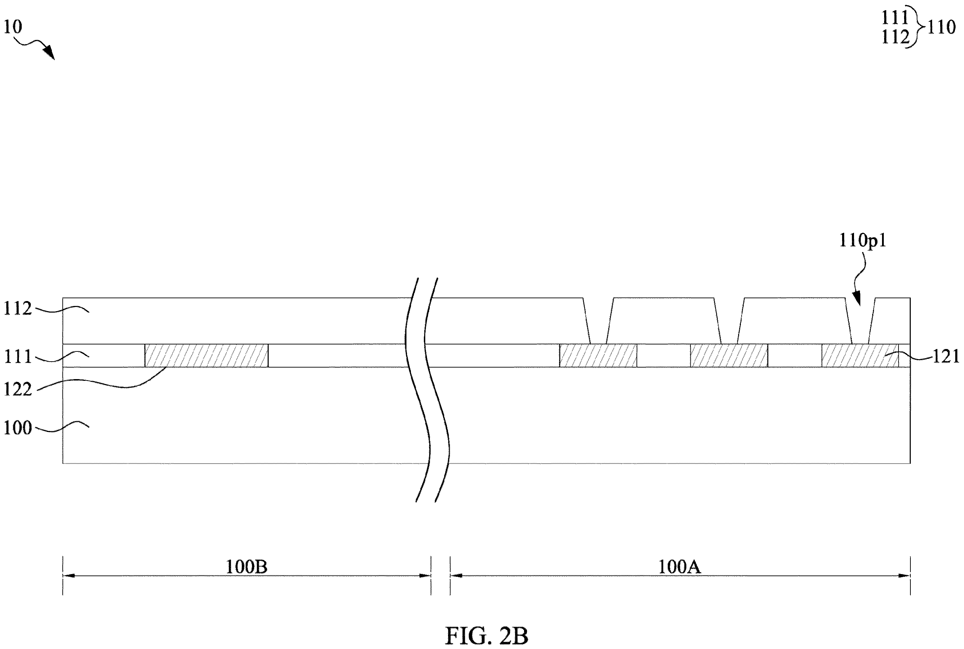

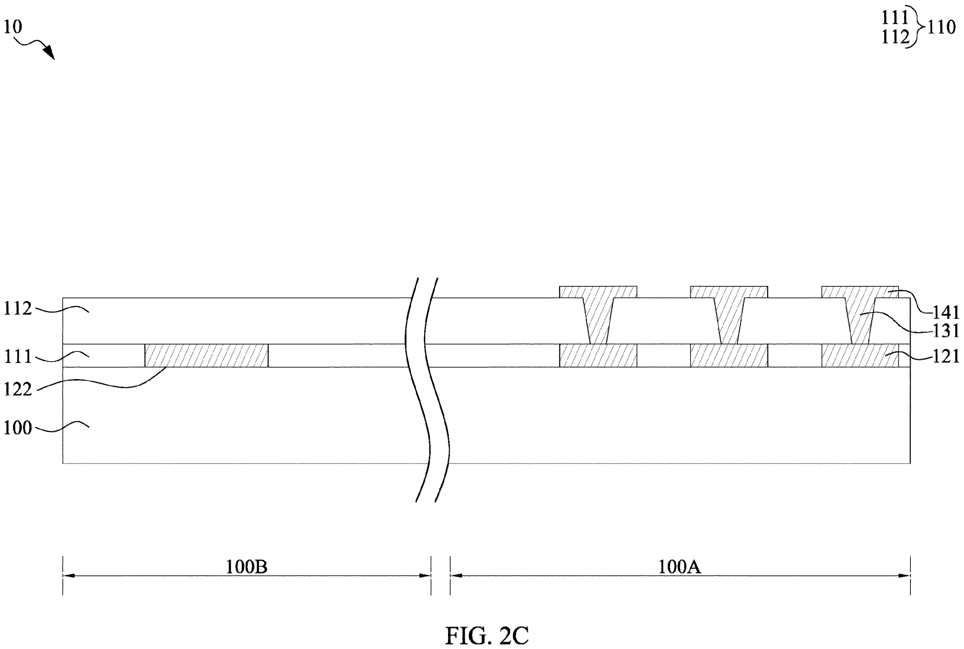

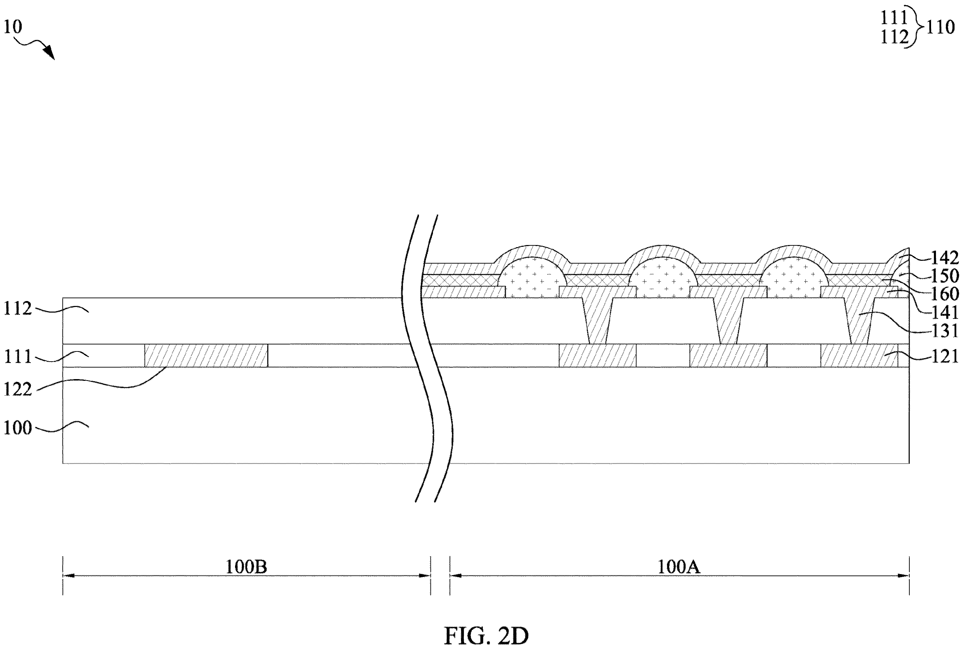

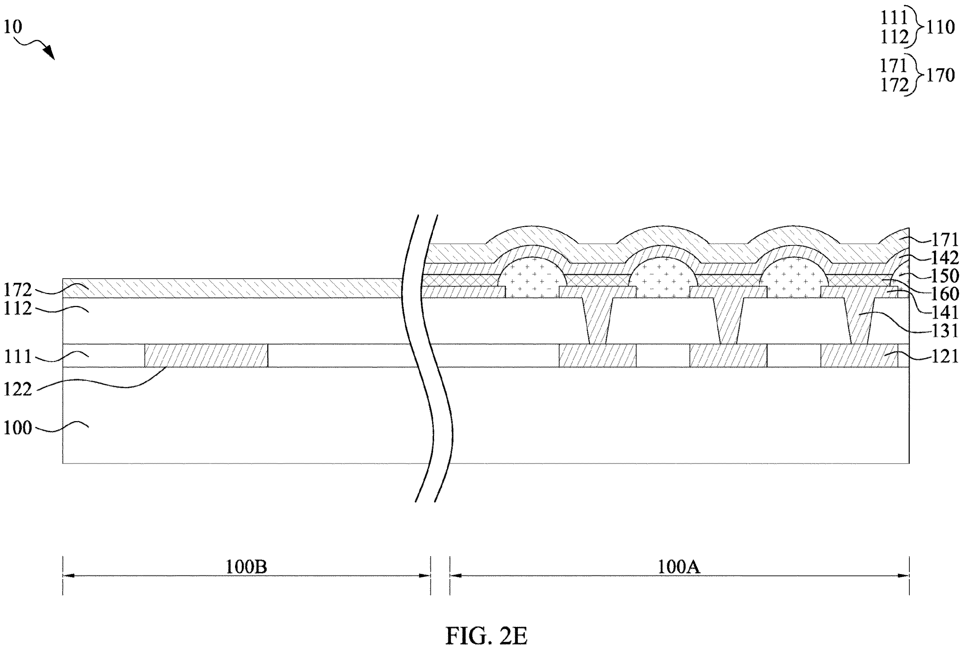

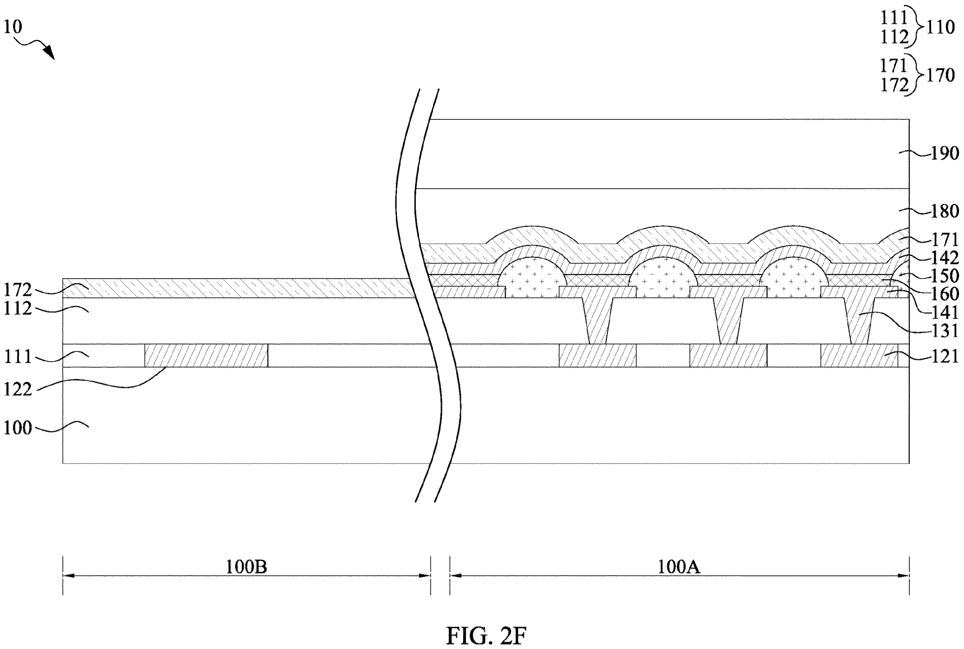

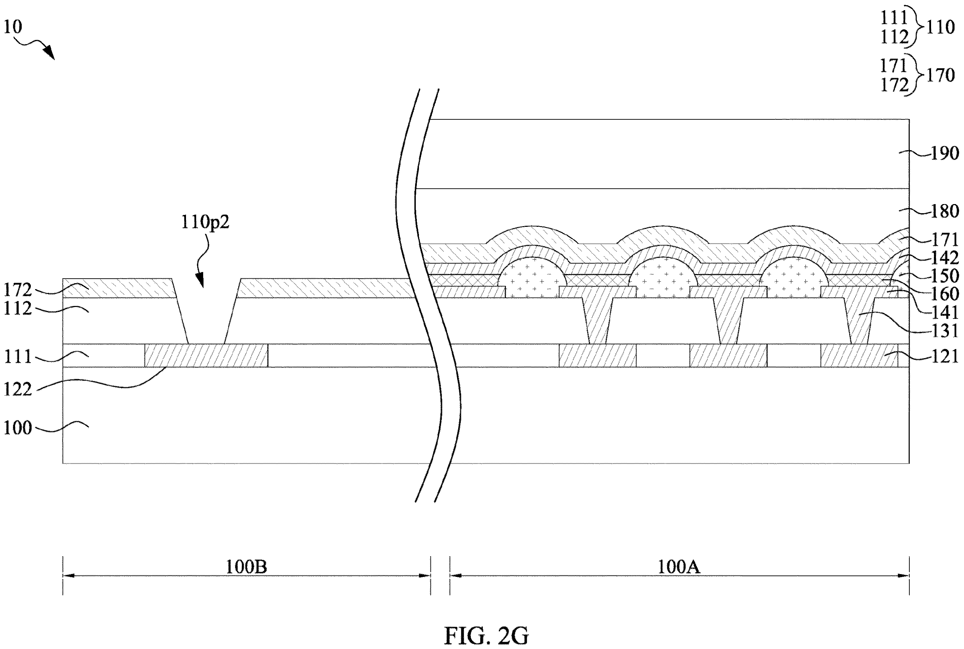

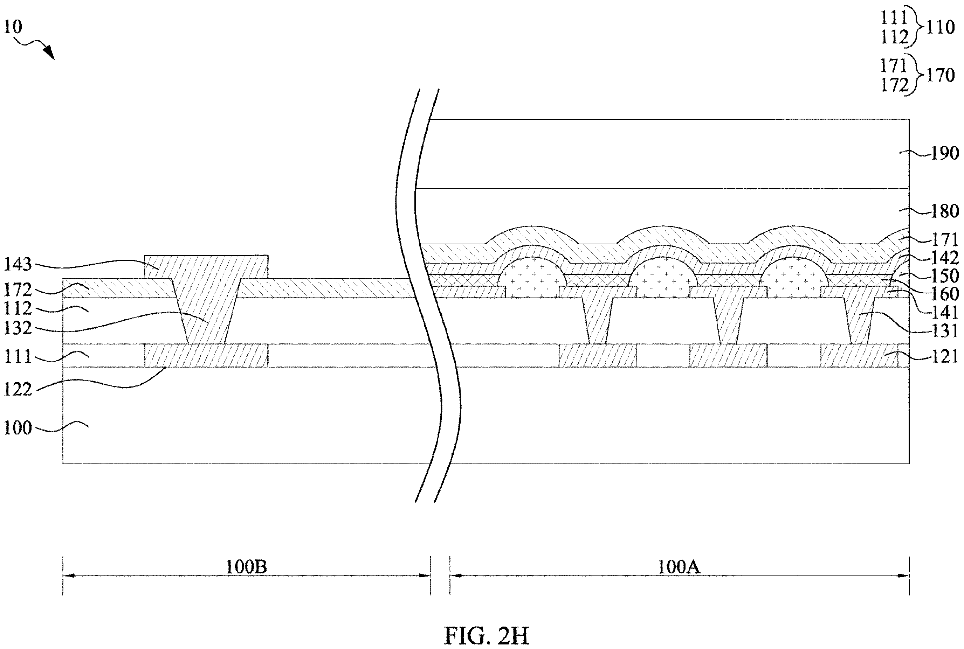

FIGS. 2A, 2B, 2C, 2D, 2E, 2F, 2G and 2H show diagrams of a display device in different manufacturing stages of a method according to some embodiments of the present disclosure.

Referring to FIG. 2A, the substrate 100 is provided or received. The passivation layer 111 is formed on the substrate 100, the interconnection conductive layer 121 is formed in the active region 100A, and the bonding pad 122 is formed in the peripheral region 100B. Next, the passivation layer 112 is formed on the interconnection conductive layer 121 and the bonding pad 122.

Referring to FIG. 2B, an opening 110p1 is formed to expose the interconnection conductive layer 121. No opening is formed above the bonding pad 122. At this stage, no opening is formed on the peripheral region. The opening 110p1 passes through the passivation layer 112. The opening 110p1 can be formed by an etching process (for example, dry etching).

Referring to FIG. 2C, the conduction via 131 is formed to fill the opening 110p1, and the electrode 141 is formed on the conduction via 131. In some embodiments, a metal material can be deposited into the conduction via 131 and cover the active region 100A. Then, the conduction via 131 and the electrode 141 are formed by a patterning step.

Referring to FIG. 2D, the pixel defining layer 150, the light emitting structure 160 and the electrode 142 are formed in the active region 100A, and then the electrode 141 is covered.

Referring to FIG. 2E, the film 170 is formed on the electrode 142. The film 170 has the portion 171 in the active region 100A, and has the portion 172 in the peripheral region 100B.

Referring to FIG. 2F, the flat layer 180 is formed on the portion 171, and the cover plate 190 is formed on the flat layer 180. The flat layer 180 and the cover plate 190 cover the active region 100A. The peripheral region 100B is not covered by the flat layer 180 or the cover plate 190.

Referring to FIG. 2G, an opening 110p2 is formed in the peripheral region 100B. The opening 110p2 passes through the portion 172 and the passivation layer 112, and exposes the bonding pad 122. The opening 110p1 can be formed by an etching process (for example, dry etching).

Referring to FIG. 2H, the conduction via 132 is formed to fill the opening 110p2, and the liner 143 is formed on the conduction via 132, so as to manufacture the display device 10.

The conduction via 131 and the conduction via 132 are formed simultaneously in conventional processes. In this case, it is possible that a difference between strain imposed on the active region 100A and the peripheral region 100B is increased due to subsequent steps performed, leading to an occurrence of mura in light emitted from pixels. In this embodiment, the conduction via 131 and the conduction via 132 are not simultaneously formed. The conduction via 132 is formed after the cover plate 190 is formed. The occurrence of mura above can be prevented. Moreover, in this embodiment, the opening 110p2 can be defined by one single etching and lithography process, and costs are reduced compared to the prior art.

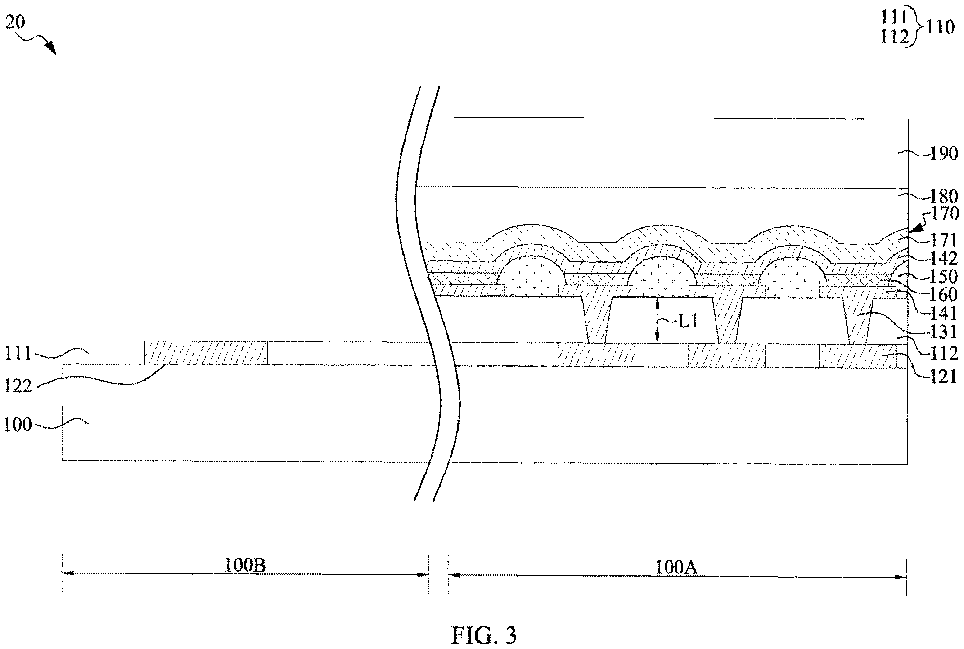

FIG. 3 shows a cross-sectional view of a display device 20 according to some embodiments. The display device 20 is similar to the display device 10, and differs in respect of the following.

In some embodiments, the bonding pad 122 can be exposed from the peripheral region 100B. That is, an external device (not shown) can be directly electrically connected to the bonding pad 122 instead of being electrically connected to the bonding pad 122 via the liner 143 and the conduction via 132 shown in FIG. 1B.

After the stage shown in FIG. 2F, the passivation layer 112 and the portion 172 of the film 170 are removed to expose the bonding pad 122, and the display device 20 can then be manufactured. In this embodiment, the bonding pad 122 may be the outer pad (or the outermost pad) within the peripheral region 100B. The dimension (e.g., width in a cross-sectional view or a diameter) of the bonding pad 122 is substantially uniform.

The features of some embodiments are given in brief in the description above for a person skilled in the art to better understand various aspects of the present disclosure. A person skilled in the art would be able to understand that the present disclosure can be used as the basis for designing or modifying other manufacturing processes and structures so as to achieve the same objects and/or the same advantages of the embodiments described in the present application. A person skilled in the art would also be able to understand that such structures do not depart from the spirit and scope of the disclosure of the present application, and various changes, substitutions and replacements may be made by a person skilled in the art without departing from the spirit and scope of the present disclosure.

In addition, the scope of the present application is not limited to the specific embodiments of the processes, machinery, manufacturing, substance compositions, means, methods or steps given in the detailed description. A person of ordinary skill in the art would be able to understand from the disclosed details of the present disclosure that existing or future processes, machinery, manufacturing, substance compositions, means, methods or steps that have the same functions or achieve substantially the same results as the corresponding embodiments given in the literature can be used according to the present disclosure. Accordingly, these processes, machinery, manufacturing, substance compositions, means, methods and steps to be encompassed within the scope of the appended claims of the present application.

## Claims

1. A display device, comprising:
a substrate (100), comprising an active region (100A) and a peripheral region (100B);
an interconnection conductive layer (121) disposed on the substrate and located in the active region;
a bonding pad (122) disposed on the substrate and located in the peripheral region;
a passivation layer (112) disposed on the interconnection conductive layer;
a first through via (131) passing through the passivation layer and electrically connected to the interconnection conductive layer;
a light emitting structure (160) disposed on the first through via; and
a film (170) disposed on the light emitting structure and covering the peripheral region of the substrate.

2. The display device according to claim 1, further comprising a second through via (132) passing through the film and electrically connected to the bonding pad, wherein an aperture of the second through via continuously decreases from the film to an upper surface of the bonding pad.

3. The display device according to claim 1 or 2, wherein a length of the second through via is greater than a length of the first through via.

4. The display device according to any of claims 1-3, wherein the film comprises a first portion (171) located in the active region and a second portion (172) located in the peripheral region, and a height of the first portion relative to the substrate is different from a height of the second portion relative to the substrate.

5. The display device according to claim 2, wherein a height of the bonding pad relative to the substrate is equal to a height of the interconnection conductive layer relative to the substrate.

6. The display device according to claim any of claims 1-5, further comprising:
a cover plate (190) covering the film, wherein the peripheral region is not covered by the cover plate.

7. The display device according to claim 2, wherein an aperture of the second through via is greater than an aperture of the first through via.

8. The display device according to claim 1, wherein the bonding pad is configured to serve as an outer pad within the peripheral region.

9. The display device according to claim 1 or 8, wherein the bonding pad is level with the interconnection conductive layer.

10. The display device according to any of claims 1, 8, and 9, wherein the bonding pad is free from being covered by the passivation layer.

11. The display device according to any of claims 1, and 8-10, wherein a diameter of the bonding pad is uniform, and a diameter of the first through via is tapered toward the substrate.

12. A method for forming a display device, comprising:
providing a substrate (100) comprising an active region and a peripheral region;
forming an interconnection conductive layer (121) on the substrate and in the active region;
forming a bonding pad (122) on the substrate and in the peripheral region;
forming a passivation layer (112) on the interconnection conductive layer and the bonding pad;
forming a first through via (131) passing through the passivation layer and electrically connected to the interconnection conductive layer;
forming a light emitting structure (160) on the first through via;
forming a film (170) on the light emitting structure and covering the active region and the peripheral region of the substrate; and
removing at least a portion of the passivation layer and the film of the peripheral region to expose the bonding pad.

13. The method according to claim 12, further comprising:
forming an opening passing through the film and the passivation layer to expose the bonding pad; and
filling the opening by a conductive layer to form a second through via (132).

14. The method according to claim 13, further comprising:
forming a cover plate (190) to cover the active region of the substrate, wherein forming of the opening is after forming of the cover plate.

15. The method according to claim 12, further comprising:
forming a cover plate (190) to cover the active region of the substrate, wherein removing at least the portion of the passivation layer and the film of the peripheral region is performed after forming the cover plate.
